# EUROPEAN PATENT APPLICATION

(11) **EP 3 764 396 A1**
(43) Date of publication of application: **13.01.2021**
(21) Application number: 19763407.4
(22) Date of filing: 05.03.2019
(51) Int. Cl.: H01L 23/473, H01L 25/07, H01L 25/18, H03F 3/24, H05K 7/20

(54) **COOLING STRUCTURE, POWER AMPLIFIER, AND TRANSMITTER**

(30) Priority: 08.03.2018 JP 2018041922
(71) Applicant: NEC Corporation, 108-8001 Tokyo (JP)
(72) Inventor: NAKAGAWA Takahiro, Tokyo 108-8001 (JP)
(74) Representative: Vossius & Partner Patentanwälte Rechtsanwälte mbB
(86) International application number: PCT/JP2019/008573
(87) International publication number: WO 2019/172233

(57) **Abstract**

The purpose of the present invention is to provide: a cooling structure with which it is possible to maintain an appropriate positional relationship between a cooling pipe and a heat-generating body and to provide sufficient cooling even when the size of the heat-generating body is similar to or smaller than the cooling pipe; a power amplifier; and a transmitter. Accordingly, the cooling structure of the present invention is provided with: a cooling pipe which includes a base material having formed a refrigerant flow passageway, and a first layer formed on an outer surface of the base material; and a cold plate with the cooling pipe cast therein. The cooling pipe is arranged at a position such that, when viewed from a heat-generating body arranged on the cold plate, the outline of the cooling pipe is present within 45 degrees from the outside of the heat-generating body.

## Description

### [Technical Field]

The present invention relates to a cooling structure, a power amplifier, and a transmitter.

### [Background Art]

PTL 1 describes an invention of a mold for blow molding as follows. A steel or copper pipe is previously bent in a predetermined manner, arranged in a mold along a surface of the mold, and inserted with an aluminum alloy. Thus, it is described that strength and rigidity of the mold can be improved, the mold wall thickness can be reduced by casting out, and a passage for a heating/cooling medium can be provided along a surface profile near the mold surface over the entire mold.

PTL 2 describes an invention of a water cooling-type cold plate. A flow path for cooling water is formed by casting a meandering metal pipe 2 in an aluminum plate 3. A cross-sectional shape of the metal pipe is flat in a part embedded in the aluminum plate and is round at a pipe tip 5.

### [Citation List]

### [Patent Literature]

[PTL 1] Japanese Unexamined Patent Application Publication No. H04-197569
[PTL 2] Japanese Unexamined Patent Application Publication No. H06-030473

### [Summary of Invention]

### [Technical Problem]

In PTLs 1 and 2, a size of a heat-generating body is larger than a size of a cooling pipe. In PTL 1, the mold itself is a heating part to be heated with molten metal during casting, and the size is naturally larger than the size of the cooling pipe. In PTL 2, as can be seen from Fig. 6, a heating part 1 has several times longer than the diameter of the metal pipe 2 even at the smallest part. Therefore, the cooling pipe can be laid several times under one heating part, and even when there is a slight error in a positional relationship between the cooling pipe and the heat-generating body part, it can be sufficiently cooled. In other words, rough arrangement of the pipe with respect to the heat-generating body does not cause great difference in cooling performance. However, when the size of the heat-generating body is substantially equal to or smaller than the size of the cooling pipe, the cooling pipe cannot be brought close to the heating part repeatedly. This problem becomes more serious when the heating part has high heat generation.

An object of the present invention is to solve the above-described problem and to provide: a cooling structure that enables a positional relationship between a cooling pipe and a heat-generating body to be appropriately maintained and sufficient cooling to be provided even when a size of the heat-generating body is substantially equal to or smaller than the cooling pipe; a power amplifier; and a transmitter.

### [Solution to Problem]

The present invention is a cooling structure that includes: a cooling pipe including a base material in which a refrigerant flow path is formed, and a first layer formed on an outer surface of the base material; and a cold plate in which the cooling pipe is cast, wherein the cooling pipe is arranged, when viewed from a heat-generating body to be arranged on the cold plate, at a position where an outline of the cooling pipe is present within a range of 45 degrees from an outside of the heat-generating body.

### [Advantageous Effects of Invention]

The present invention is able to provide: the cooling structure that enables sufficient cooling to be provided even when a size of the heat-generating body is substantially equal to or smaller than the cooling pipe; a power amplifier; and a transmitter.

### [Brief Description of Drawings]

[Fig. 1] Fig. 1 is a cross-sectional view of a cooling structure according to a first example embodiment of the present invention.
[Fig. 2] Fig. 2 is a plan view of the cooling structure according to the first example embodiment of the present invention.
[Fig. 3] Fig. 3 is a perspective view of a power amplifier including the cooling structure according to the first example embodiment of the present invention.
[Fig. 4] Fig. 4 is a perspective view of a broadcast transmitter including the power amplifier in Fig. 3.
[Fig. 5] Fig. 5 is a cross-sectional view for describing a second example embodiment of the present invention.
[Fig. 6] Fig. 6 is the cross-sectional view for describing the second example embodiment of the present invention.
[Fig. 7] Fig. 7 is the cross-sectional view for describing the second example embodiment of the present invention.
[Fig. 8] Fig. 8 is a cross-sectional view for illustrating a third example embodiment of the present invention.
[Fig. 9] Fig. 9 is the cross-sectional view for illustrating the third example embodiment of the present invention.
[Fig. 10] Fig. 10 is a cross-sectional view for illustrating a fourth example embodiment of the present invention.
[Fig. 11] Fig. 11 is a plan view for illustrating a fifth example embodiment of the present invention.
[Fig. 12] Fig. 12 is a cross-sectional view of a cooling structure according to a sixth example embodiment of the present invention.
[Fig. 13] Fig. 13 is a cross-sectional view of a cooling structure according to a seventh example embodiment of the present invention.

### [Example Embodiment]

### (First Example Embodiment)

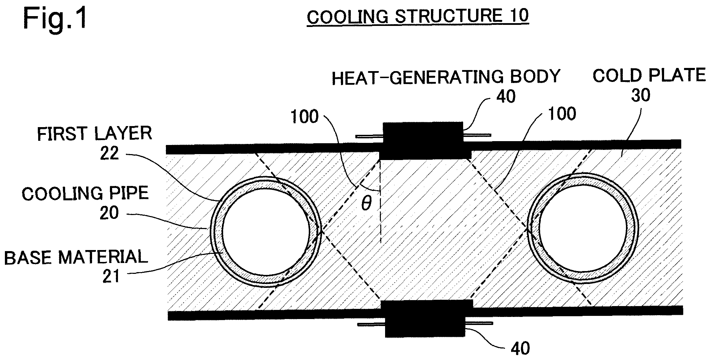

A cooling structure 10 according to a first example embodiment of the present invention is described by using Fig. 1. Fig. 1 is a cross-sectional view of the cooling structure 10. The cooling structure 10 includes a cooling pipe 20 (hereinafter, abbreviated as a pipe) and a cold plate 30 (hereinafter, abbreviated as a plate). The plate 30 is a flat plate-shaped structure having a predetermined thickness. The shape of the plate 30 is substantially rectangular according to the present example embodiment, but may be other shapes. A heat-generating body 40 is mounted on the plate 30 and is a high-output field effect transistor (FET) according to the present example embodiment. In Fig. 1, the heat-generating body 40 is installed in a hollow formed by digging a surface of the plate 30. The pipe 20 is cast in the plate 30, and the pipe 20 is constituted of a base material 21 having a shape of the pipe in which a flow path for cooling water is formed and a first layer 22 on an outer surface of the base material. A diameter of the pipe 20 is substantially equal to a width of the heat-generating body 40.

In Fig. 1, a dashed line 100 illustrates a 45-degree line from an end of the upper and lower heat-generating bodies 40. The pipe 20 may be arranged, when viewed from the end of the heat-generating body 40, at a position where an outline of the pipe 20 is present within a range of θ = 45 degrees from an outside the heat-generating body. Fig. 1 illustrates a state in which the outline of the pipe 20 is exactly in contact with an intersection of two 45-degree dashed lines 100, more specifically, Fig. 1 illustrates a state in which the pipe 20 is located at the outermost place from right side and left side of the heat-generating body 40, i.e., at the two farthest places from the heat-generating body 40. The outline of the pipe 20 may be in contact with somewhere inside the region surrounded by the dashed lines in Fig. 1. By arranging a pipe in such a positional relationship with respect to a high heat-generating body, the high heat-generating body and the pipe can be extremely brought close to each other, thereby enabling sufficient cooling to be provided even when the size of the heat-generating body is substantially equal to or smaller than the size of the pipe.

In PTL 1, the mold itself is a heating part to be heated with molten metal during casting, and the size is much larger than the size of the cooling pipe. In PTL 2, the heating part has several times longer than the diameter of the metal pipe even at the smallest part. In PTLs 1 and 2, even when there is a slight error in the positional relationship between the cooling pipe and the heat-generating body part, the cooling pipe can be laid several times under one heating part, and thus the heat-generating body part can be sufficiently cooled. However, as the present example embodiment, when a size of a heat-generating body is substantially equal to or smaller than a size of a cooling pipe, the cooling pipe cannot be brought close to the heating part repeatedly. This problem becomes more serious when the heating part has high heat generation. According to the present example embodiment, however, the high heat-generating body and the pipe can be extremely brought close to each other as described above, and thus the problem can be solved.

As the base material 21 of the pipe 20, a material with high thermal conductivity, for example, copper (Cu), an alloy containing copper, stainless steel, graphite, or the like is used. The first layer 22 is a coating layer formed on the outer surface of the base material 21 by plating or the like, and usually a material different from the base material is used. As the material, a coating layer by graphite coating, spraying, or the like is used, or a plating layer of iron (Fe), chromium (Cr), silver (Ag), gold (Au), titanium (Ti), other metals or an alloy of these metals can be used. For example, a copper pipe is coated with graphite. The high thermal conductivity of the base material means that heat can be transferred to cooling water enough to cool a heat-generating body to a desired temperature.

A material of the plate 30 is preferably aluminum or an aluminum alloy. A reason for this is that aluminum has high thermal conductivity, and thus cooling performance of cooling water for cooling a heat-generating body can be sufficiently exhibited.

When it is necessary to electrically remove a space (cavity) formed inside the plate 30 during casting, it is preferable to adopt pure aluminum in which the space is relatively hard to occur.

A thickness of the first layer 22 is not particularly limited as long as the cooling performance of the cooling water flowing in the pipe 20 can be sufficiently exhibited and the pipe 20 is not damaged by molten metal of the plate 30. Further, the inner diameter and the wall thickness of the pipe 20 are not particularly limited.

The thickness of the plate 30 is not particularly limited as well, as long as it is larger than the outer diameter of the pipe 20 and the cooling performance of the cooling water can be sufficiently exhibited. The plate 30 may be formed by forming the plate 30 to be slightly thicker than a desired thickness and then cutting the plate 30 to a desired thickness.

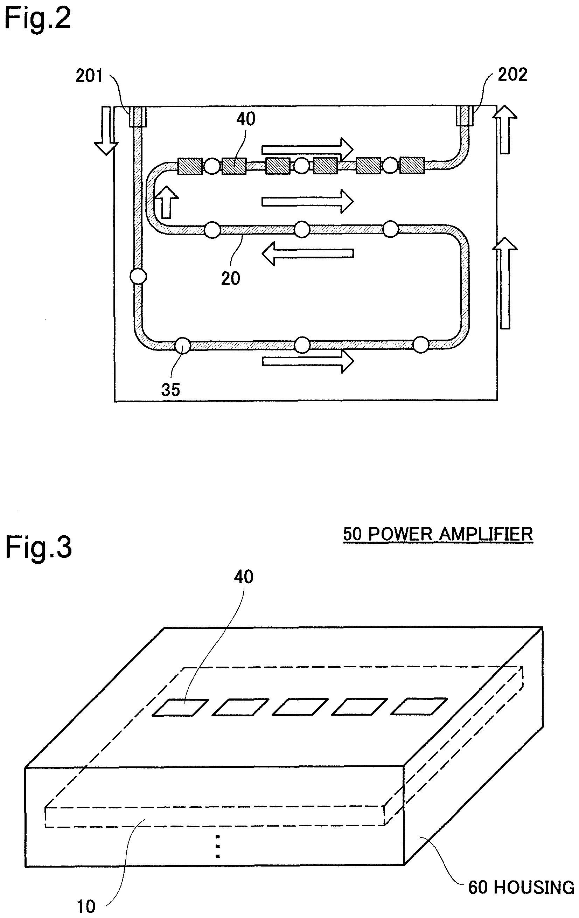

Fig. 2 is a plan view of the cooling structure 10 in Fig. 1 viewed from above the plate 30. The pipe 20 is meanderingly arranged in such a way as to pass under a position where the heat-generating bodies 40 are arranged. A planar shape of the heat-generating body 40 is substantially rectangular, and has a longitudinal direction (length direction) and a lateral direction (width direction). Actually, the pipe 20 is cast in the plate and cannot be seen from the outside, but in Fig. 2 it is exposed and displayed. An arrow in the figure illustrates the direction of flowing cooling water. The pipe 20 is connected to an external hose with pipe ends 201 and 202 provided on the side face of the plate in such a way that the cooling water can be circulated. In Fig. 2, the pipe ends 201 and 202 are provided on the same side face of the plate 30, but may be provided on different side faces.

On the plate 30, six heat-generating bodies are arranged linearly in the longitudinal direction of the heat-generating body, and the pipe runs under the heat-generating bodies in the plate. Six heat-generating bodies are linearly mounted also on the back side of the plate 30 in the length direction of the heat-generating body (not illustrated in Fig. 2). A retainer is provided in the mold in such a way that the pipe 20 does not move in the mold during casting and a pipe retainer 35 in Fig. 2 results from the shape of the retainer being moved to the plate 30.

In Figs. 1 and 2, the heat-generating body 40 is mounted on both surfaces of the plate 30, but may be mounted on only one surface. In such case, similarly, the outline of the pipe 20 may be present, from the end of the heat-generating body 40, within a range of θ = 45 degrees from the outside the heat-generating body.

Fig. 3 is a perspective view of a power amplifier 50 that includes the cooling structure 10 in Figs. 1 and 2. The power amplifier 50 is configured by mounting, as the heat-generating body 40, for example, a capacitor, an inductor, a resistor, and the like other than the FET on the plate, wiring with a coaxial cable, or the like, and being housed in a housing. Fig. 3 does not illustrate a part other than the FET. Only one cooling structure 10 is illustrated in Fig. 3, but a plurality of cooling structures may be stacked.

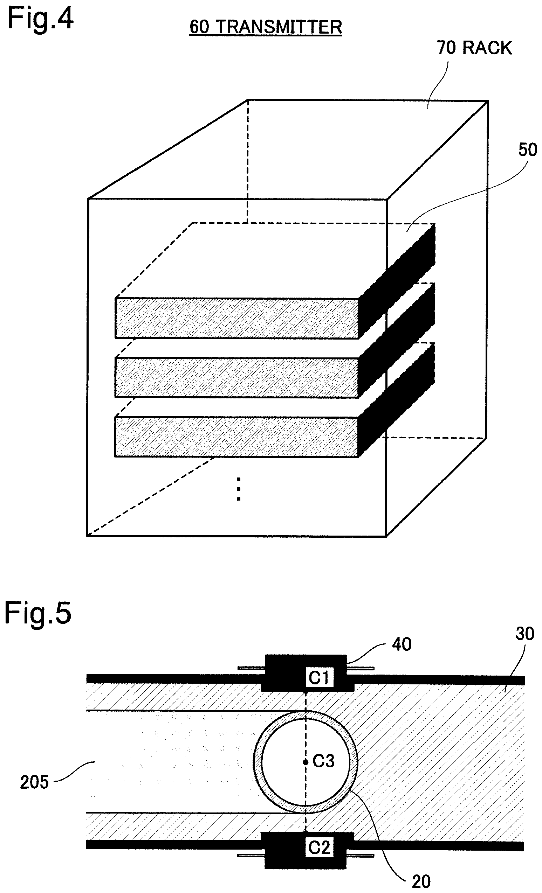

Fig. 4 is a perspective view of a broadcast transmitter 60 that includes the power amplifier 50 described in Fig. 3. A plurality of power amplifiers 50 including the cooling structure 10 are housed in a rack 70. The power amplifier 50 amplifies a broadcasting radio wave and outputs the amplified radio wave to an antenna (not illustrated). In the case of digital terrestrial broadcasting, a frequency of a transmission radio wave is several hundred MHz. The number of power amplifiers 50 is not particularly limited, but is set according to required output and the like. In addition to the power amplifier 50, the broadcast transmitter 60 includes a control unit that controls the power amplifier 50 and a cooling water inflow/outflow mechanism (neither is illustrated).

Hereinafter, a heating value, a size, and the like when the heat-generating body is the FET are described. The heating value for one FET varies according to the type of the FET, but is 100 W, 150 W, 200 W or more, for example. When the FET with 150W is mounted on a package, an outer planar size of the package is about 40mm × about 10mm, and the heating value per 1mm² is 150W / (40mm × 10mm) = 375mW, and thus the heating value per area is extremely high.

The plate is rectangular and the planar size is several hundred mm in each of length and width, and the thickness is 20 mm to 30 mm. The outer diameter of the pipe is about 12 to 13 mm, which is larger than the width of the FET of 10 mm. When the thickness of the plate is 25 mm and the outer diameter of the pipe is 12 mm, a position where the pipe and the FET are closest to each other is (25 - 12) / 2 = 6.5 mm, and both are extremely close to each other, thereby improving cooling efficiency.

There are various FETs to be used, including a FET having the same width as the pipe having the outer diameter of 13 mm or a FET of which width is 1 or 2 mm larger than the pipe having the outer diameter of 13 mm. The pipe to be laid meanderingly in one plate has a length of about 1000 mm to 2000 mm, which is extremely longer and several tens of times longer than one example (about 40 mm) of the length of one FET. When the FET is arranged in the length direction parallel to a direction in which the pipe is extended, the length of the pipe is 25 to 50 times longer than the length of one FET acquired by 1000 / 40 to 2000 / 40.

### (Second Example Embodiment)

Fig. 5 is a cross-sectional view for describing a second example embodiment of the present invention. According to the present example embodiment, a pipe 20 is cast in such a way as to be located directly under a heat-generating body 40 mounted on both surfaces of a plate 30. In Fig. 5, a base material 21 and a first layer 22 of the pipe 20 are integrally illustrated. The pipe 20 is bent to the left at the back of the figure and that is illustrated as 205.

According to the present example embodiment, the upper and lower heat-generating bodies 40 are mounted in such a way as to be at the same position when viewed from above a main surface (a surface having a large area) of the plate 30, and the pipe 20 is also arranged in such a way that a center c3 of the pipe 20 is located on a line connecting a center c1 and a center c2 of the upper and lower heat-generating bodies 40. The arrangement in such a positional relationship enables one pipe 20 to be brought close to the two heat-generating bodies 40, and the heat radiation from the heat-generating body 40 reaches the pipe 20 efficiently. The heat that reaches the pipe 20 is discharged by cooling water flowing through the pipe. When heating values of the two heat-generating bodies 40 are the same, the center c3 of the pipe 20 may be located equidistant from the two heat-generating bodies 40, that is, at the center of the above-described line.

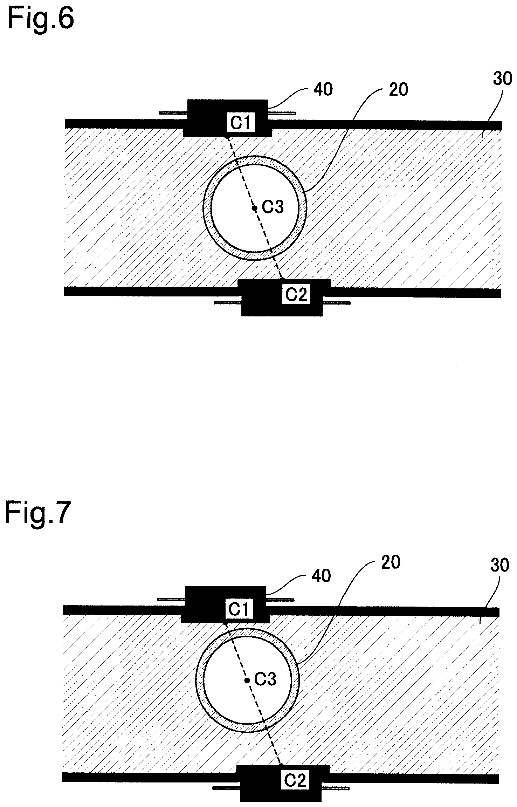

However, depending on design, the upper and lower heat-generating bodies 40 may not be at the same position when viewed from above the plate 30, and may be deviated. In this case, as illustrated in Fig. 6, the pipe 20 may be arranged in such a way that the center c3 of the pipe 20 is located on the line connecting the center c1 and the center c2 of the upper and lower heat-generating bodies 40.

When the heating values of the two heat-generating bodies 40 are different due to the design or the like, the pipe 20 may be arranged not equidistantly but to be located near the heat-generating body with a larger heating value. For example, when a ratio of the heating value of the two heat-generating bodies is 2:1, the line connecting the centers of the upper and lower heat-generating bodies is divided into the ratio of 1:2 and the center of the pipe 20 is arranged in such a way as to be located at the position of "1" of the ratio of 1:2 as illustrated in Fig. 7. Since the pipe has a diameter, the arrangement in this way may cause the pipe to come in contact with the heat-generating body with a larger heating value, or a distance between the pipe and the heat-generating body to become too close to charge molten metal sufficiently during casting. In this case, as far as a manufacturing technique allows, the pipe is arranged in such a way as to be closer to the position "1".

### (Third Example Embodiment)

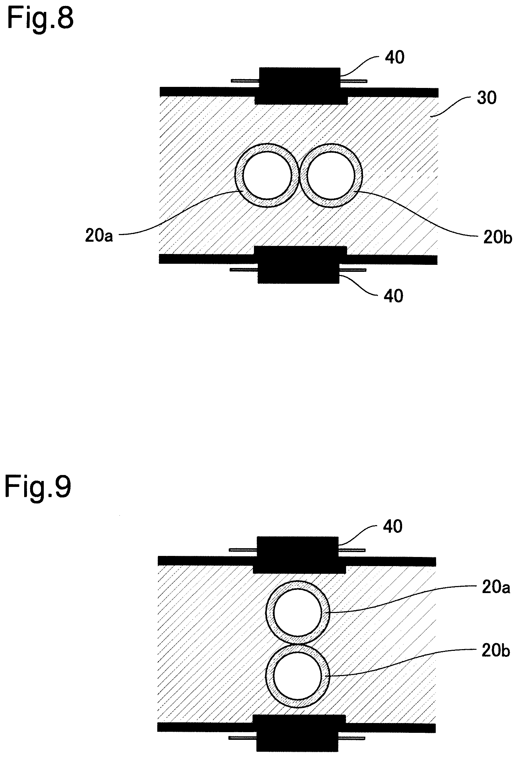

Figs. 8 and 9 are cross-sectional views for illustrating a third example embodiment of the present invention. There is no change in casting in such a way that a pipe is located directly under a heat-generating body 40, but the present example embodiment uses two pipes (cooling pipes 20a and 20b). The cooling pipe 20a and the cooling pipe 20b are in contact with each other. In Fig. 8, two pipes are arranged in the direction parallel to a main surface of a plate 30, and a diameter of each cooling pipe 20a and 20b is smaller than the diameter in the case of arranging only one pipe. When two pipes are used, the surface area of the pipe viewed from the heat-generating body 40 is increased as compared to the case of arranging one pipe, and even when other condition such as a flow rate of cooling water is the same, cooling efficiency is improved as compared to the case of arranging one pipe.

In Fig. 9, two pipes 20a and 20b are arranged in a thickness direction of the plate 30. The diameter of each cooling pipe 20a and 20b is smaller than the diameter in the case of arranging only one pipe.

### (Fourth Example Embodiment)

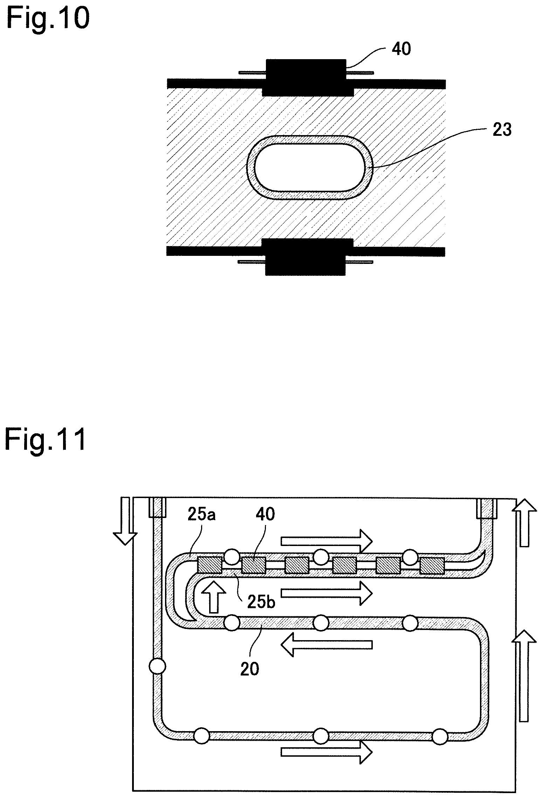

Fig. 10 is a cross-sectional view for illustrating a fourth example embodiment of the present invention. According to the present example embodiment, a cooling pipe 23 has a cross section of a flat shape instead of a circular shape. In Fig. 10, a diameter of the pipe 23 in a thickness direction of a plate 30 is smaller than the diameter in a direction of a main surface of the plate 30. In Fig. 10, the cross section of the pipe has a shape similar to a track for athletics. A long side of the flat shape, that is, the side equivalent to a straight course of the track in Fig. 10, is arranged in such a way as to face a heat-generating body 40. The arrangement in this way enables the thickness of the plate 30 to be reduced, and a ratio of an area of the flat pipe to the area of the main surface of the plate 30 is increased, thereby improving cooling efficiency. In other words, the cross-sectional area of the pipe can be increased when the thickness of the plate is limited.

The entire pipe cast in the plate 30 may have a flat shape, or only a part of the pipe under the heat-generating body may have a flat shape. Further, the shape of the cross section of the pipe may be an ellipse that is long in the direction of the main surface of the plate or the like, or may be made by two pipes as illustrated in Figs. 8 and 9.

### (Fifth Example Embodiment)

Fig. 11 is a plan view for illustrating a fifth example embodiment of the present invention. In Fig. 5, one pipe is arranged under the heat-generating body 40, but according to the present example embodiment, a cooling pipe 20 is branched into two pipes 25a and 25b under a heat-generating body 40 and cast in such a way as to be located diagonally downward from the heat-generating body 40 in a plate 30. In the same way as the first example embodiment, according to the present example embodiment, the branch cooling pipes 25a and 25b are each cast within a range of 45 degrees viewed from the heat-generating body in the plate 30. Each diameter of the branch cooling pipes 25a and 25b is half of the diameter of the cooling pipe 20. The outer diameters of the branch cooling pipes 25a and 25b are the same. The inner diameters are also the same between the two pipes.

When a pipe is directly under a heat-generating body, the pipe can be cooled more efficiently as long as other condition is the same, but the pipe may not be arranged directly under the heat-generating body for some reason or, even when the pipe can be arranged under the heat-generating body, the pipe may need to be distanced from the heat-generating body. In this case, as the present example embodiment, the pipe is branched and the heat-generating body is cooled from diagonally under both side faces of the heat-generating body. For example, branching is effective in the following case. When a screw hole is opened on the surface of the plate 30 and the heat-generating body is fixed to the plate 30, a male screw is screwed into the screw hole and a terminal of the heat-generating body is fixed between the male screw and the plate 30. The screw hole cannot be in contact with the pipe 20, and thus the screw hole needs to be opened at a position where the pipe 20 is not arranged. Therefore, when the pipe 20 is to be arranged directly under the heat-generating body, the distance between the heat-generating body and the pipe needs to be increased. When a heating value of the heat-generating body is large, there is a possibility that sufficient cooling may not be provided. However, according to the present example embodiment, the pipe is branched to both sides of the heat-generating body 40, thereby avoiding overlapping with the screw hole.

In Fig. 10, the pipe is branched into two pipes under the heat-generating body, but the pipe may be branched into three or more, for example. Further, a cross-section shape of the branched pipe may be flat as illustrated in Fig. 10.

### (Sixth Example Embodiment)

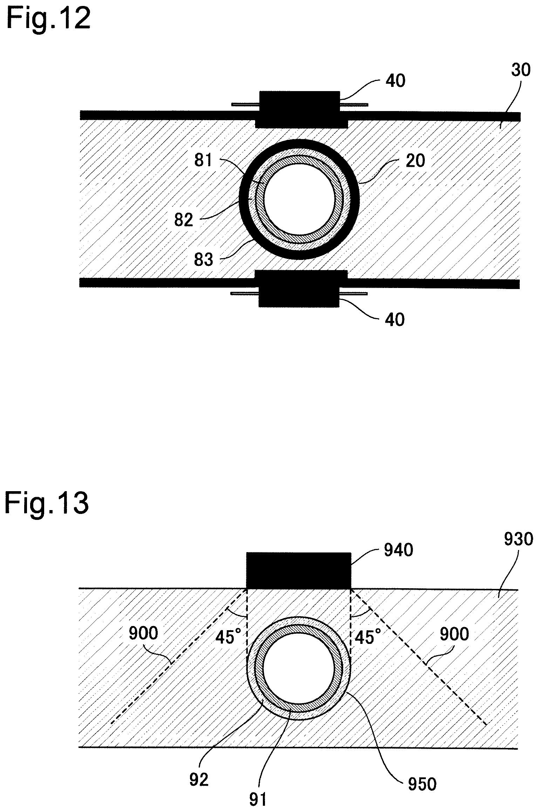

Fig. 12 is a cross-sectional view of a cooling structure 10 according to a sixth example embodiment of the present invention. According to the above-described example embodiments, the coating layer formed on the surface of the pipe is one layer, but according to the present example embodiment, two layers are formed. A pipe 20 includes a copper pipe 81 being a base material having a pipe shape, a first plating layer 82 being a first layer formed on an outer surface of the copper pipe 81, and a second plating layer 83 being a second layer formed on the outside of the first plating layer 82.

A base material is a pipe in which a flow path for cooling water is formed. The base material is constituted of a material (a first material) with high thermal conductivity. The high thermal conductivity of the base material means that heat can be transferred to cooling water enough to cool a heat-generating body to a desired temperature. The material with high thermal conductivity is, for example, a material with higher thermal conductivity than stainless steel. The material of the base material according to the present example embodiment is preferably copper. A reason for this is that the copper pipe 81 has high thermal conductivity, high corrosion resistance, and is inexpensive, and thus a production cost of the cooling structure 10 can be suppressed. Then, the description according to the present example embodiment is provided assuming that the base material is a copper pipe. The material of the base material is not limited to copper, but may be an alloy including copper.

The first layer is formed on the outer surface of the copper pipe 81. The first layer is constituted of a material (a second material) that has heat resistance to the extent that does not melt in molten metal during casting and has high affinity with a material of the plate 30. The first layer is preferably iron plating constituted of iron. A reason for this is that iron plating constituted of iron has high heat resistance, and thus iron plating does not melt in high-temperature molten metal (molten metal of the material of the plate 30) during casting. As a result, it is possible to prevent the copper pipe 81 from coming into contact with the high-temperature molten metal. Then, the description according to the present example embodiment is provided assuming that the first plating layer 82 being the first layer is iron plating. The first layer is not limited to iron plating constituted of iron, but may be chrome plating, nickel plating, or any other material with heat resistance and high affinity with the material of the plate 30.

The second layer is formed on the surface of the first plating layer 82. The second layer is constituted of a material (a third material) that has high affinity with the material of the first layer and has high affinity with the material of the plate 30. The high affinity with the material of the plate 30 means that, during casting, the third material has good wettability with the plate material and a space (cavity) is unlikely to occur inside the plate. The material of the second layer is preferably a material that at least partially melts by molten metal to be used for forming the plate 30. By melting the second layer at least partially by the molten metal during casting, the first layer and the plate 30 that are constituted of the materials with high affinity with each other can be bonded via the melting second layer constituted of the material with high affinity with the first layer and the plate 30. As the second layer, a material including silver plating constituted of silver (Ag), gold plating constituted of gold (Au), titanium plating constituted of titanium (Ti), other metals or an alloy of these metals can be used.

As described above, the pipe 20 is preferably the copper pipe 81 to which the first plating layer 82 is applied, and further to which the second plating layer 83 is applied. Further, as described above, the pipe 20 formed along the heat-generating body 40 is cast inside the plate 30, and thus the pipe 20 is arranged in a position where the heat-generating body 40 can be cooled effectively as illustrated in Figs. 1 to 11. Therefore, the cooling structure 10 can cool the heat-generating body 40 effectively by cooling water flowing through the flow path of the pipe 20.

The pipe 20 is formed into a shape along the heat-generating body 40 before casting, and timing for forming such a shape may be after the first plating layer 82 and the second plating layer 83 are applied, however, the timing is preferably before the first plating layer 82 and the second plating layer 83 are applied. In other words, the pipe 20 is preferably formed by applying the first plating layer 82 and the second plating layer 83 to the copper pipe 81 formed along the heat-generating body 40. A reason for this is that the first plating layer 82 and the second plating layer 83 can be evenly applied to the entire copper pipe 81.

The plate 30 is formed into a plate shape by casting the pipe 20 (the copper pipe 81 to which the first plating layer 82 and the second plating layer 83 are applied) inside using a mold. The plate 30 is constituted of a material (a fourth material) that has high thermal conductivity and has high affinity with the second material and the third material. The high thermal conductivity of the fourth material means that heat can be transferred to a pipe enough to cool a heat-generating body to a desired temperature. The high affinity with the second material and the third material means that, during casting, the fourth material has good wettability between the second material and the third material and a space (cavity) is unlikely to occur inside the plate.

The cooling structure 10 according to the present example embodiment is able to increase flexibility of a shape of the flow path for cooling water and exhibit cooling performance of the cooling structure 10 without increasing the size.

For example, as described above, a cooling structure formed by charging molten metal into a mold in which a metal pipe of copper or the like is provided takes a longer time to decrease a temperature of the molten metal inside the mold, as the size of the cooling structure increases, resulting in the metal pipe being exposed to high temperature for a long time. Therefore, for example, in the case of a cooling structure with a size of about 100 mm × 100 mm, a metal pipe can be cast while having a function of the metal pipe, however, in the case of a cooling structure with a size larger than the above, the metal pipe may be deformed or melted during casting, and thus there is a possibility that cooling water cannot flow sufficiently.

However, in the cooling structure 10 according to the present example embodiment, the pipe 20 is formed by the first plating layer 82 constituted of the material with heat resistance on the surface of the copper pipe 81, and thus the copper pipe 81 does not melt out by the molten metal. Further, the second layer (the second plating layer 83) formed by the material with high affinity with the material of the first plating layer 82 and the material of the plate 30 is formed on the surface of the first plating layer 82. This enables the plate 30 in which the pipe 20 is cast to be bonded with the pipe 20 easily. Therefore, the heat-generating body 40 to be mounted on the cooling structure 10 can be sufficiently cooled by cooling water flowing through the pipe 20, and the cooling performance of the cooling structure 10 can be sufficiently exhibited.

Therefore, the cooling structure 10 according to the present example embodiment can be also used for a device having a large-size cooling structure 10 such as a transmitter. The cooling structure 10 according to the present example embodiment may be any equipment as long as it is the cooling structure 10 to be mounted on a power amplifier 50 being housed in a rack and used. For example, the cooling structure 10 according to the present example embodiment can be applied to a cooling server for cooling drinking water, and the like.

### (Seventh Example Embodiment)

Fig. 13 is a cross-sectional view of a cooling structure 90 according to a seventh example embodiment of the present invention.

The cooling structure 90 includes a cooling pipe 950 and a cold plate 930 in which the cooling pipe 950 is cast. A heat-generating body 940 is arranged on the cold plate 930. The cooling pipe 950 includes a base material 91 in which a refrigerant flow path is formed and a first layer 92 formed on an outer surface of the base material 91. The cooling pipe 950 is arranged, when viewed from the heat-generating body to be arranged on the cold plate 930, at a position where an outline of the cooling pipe is present within a range of 45 degrees from an outside of the heat-generating body.

In Fig. 13, a dashed line 900 illustrates a 45-degree line from the heat-generating body 940. The cooling pipe 950 may be arranged, when viewed from the heat-generating body 940, at a position where the outline of the pipe 950 is present within a range of two dashed lines 900. Even when the heat-generating body 940 is a high heat-generating body, the high heat-generating body and the cooling pipe can be extremely brought close to each other by arranging the cooling pipe in such a positional relationship, thereby enabling sufficient cooling to be provided even when the size of the heat-generating body is substantially equal to or smaller than the size of the cooling pipe.

### (Other Example Embodiments)

In the description according to the above-described example embodiments, a heat-generating body is cooled by flowing water through a pipe, however it is also possible to use a boiling / cooling method using a refrigerant having a boiling point lower than that of water, such as alternative chlorofluorocarbon.

It is also possible to combine the above-described example embodiments. For example, a flat pipe can be branched, and the like.

The whole or part of the example embodiments disclosed above can be described as, but not limited to, the following supplementary notes.

### (Supplementary Note 1)

A cooling structure including:
a cooling pipe that includes a base material in which a refrigerant flow path is formed and a first layer formed on an outer surface of the base material; and
a cold plate in which the cooling pipe is cast, wherein
the cooling pipe is arranged, when viewed from a heat-generating body to be arranged on the cold plate, at a position where an outline of the cooling pipe is present within a range of 45 degrees from an outside of the heat-generating body.

### (Supplementary Note 2)

The cooling structure according to supplementary note 1, wherein
a heating value per the heat-generating body is at least 100W.

### (Supplementary note 3)

The cooling structure according to supplementary note 1 or 2, wherein
the heat-generating body is provided on both surfaces of the cold plate.

### (Supplementary note 4)

The cooling structure according to any one of supplementary notes 1 to 3, wherein
a size of the heat-generating body is substantially equal to or smaller than a diameter of the cooling pipe.

### (Supplementary note 5)

The cooling structure according to any one of supplementary notes 1 to 4, wherein
a length of the cooling pipe in the cold plate is several tens of times longer than a size of the heat-generating body.

### (Supplementary note 6)

The cooling structure according to any one of supplementary notes 1 to 5, wherein
the cooling pipe is provided directly under the heat-generating body in the cold plate.

### (Supplementary note 7)

The cooling structure according to any one of supplementary notes 1 to 6, wherein
the cooling pipe is divided into a plurality of pipes and the pipes are in contact with one another.

### (Supplementary note 8)

The cooling structure according to any one of supplementary notes 1 to 7, wherein
a cross section of the cooling pipe is a flat shape in a thickness direction of the cold plate.

### (Supplementary note 9)

The cooling structure according to any one of supplementary notes 1 to 8, wherein
the cooling pipe is branched into a plurality of pipes under the heat-generating body.

### (Supplementary note 10)

The cooling structure according to any one of supplementary notes 1 to 9, wherein
the base material is formed of a first material with high thermal conductivity,
a second layer is formed on an outside of the first layer, the first layer is constituted of a second material with heat resistance, and the second layer is constituted of a third material with high affinity with the second material,
the cold plate is constituted of a fourth material with high thermal conductivity, and
the second material and the third material each have high affinity with the fourth material.

### (Supplementary note 11)

A power amplifier including
the cooling structure according to any one of supplementary notes 1 to 10.

### (Supplementary note 12)

A transmitter including
the power amplifier according to supplementary note 11.

While the invention has been particularly shown and described with reference to example embodiments thereof, the invention is not limited to these embodiments. It will be understood by those of ordinary skill in the art that various changes in form and details may be made therein without departing from the spirit and scope of the present invention as defined by the claims.

This application is based upon and claims the benefit of priority from Japanese patent application No. 2018-041922, filed on March 8, 2018, the disclosure of which is incorporated herein in its entirety by reference.

### [Reference signs List]

- 10, 90: Cooling structure
- 20, 20a, 20b, 23, 205, 950: Cooling pipe
- 21, 91: Base material
- 22, 92: First layer
- 25a, 25b: Branch cooling pipe
- 30, 930: Cold plate
- 35: Pipe retainer
- 40, 940: Heat-generating body
- 50: Power amplifier
- 60: Broadcast transmitter
- 70: Rack
- 100, 900: 45-degree dashed line
- 201, 202: Pipe end

## Claims

1. A cooling structure comprising:
a cooling pipe that includes a base material in which a refrigerant flow path is formed and a first layer formed on an outer surface of the base material; and
a cold plate in which the cooling pipe is cast, wherein
the cooling pipe is arranged, when viewed from a heat-generating body to be arranged on the cold plate, at a position where an outline of the cooling pipe is present within a range of 45 degrees from an outside of the heat-generating body.

2. The cooling structure according to claim 1, wherein
a heating value per the heat-generating body is at least 100W.

3. The cooling structure according to claim 1 or 2, wherein
the heat-generating body is provided on both surfaces of the cold plate.

4. The cooling structure according to any one of claims 1 to 3, wherein
a size of the heat-generating body is substantially equal to or smaller than a diameter of the cooling pipe.

5. The cooling structure according to any one of claims 1 to 4, wherein
a length of the cooling pipe in the cold plate is several tens of times longer than a size of the heat-generating body.

6. The cooling structure according to any one of claims 1 to 5, wherein the cooling pipe is provided directly under the heat-generating body in the cold plate.

7. The cooling structure according to any one of claims 1 to 6, wherein
the cooling pipe is divided into a plurality of pipes and the pipes are in contact with one another.

8. The cooling structure according to any one of claims 1 to 7, wherein
a cross section of the cooling pipe is a flat shape in a thickness direction of the cold plate.

9. The cooling structure according to any one of claims 1 to 8, wherein
the cooling pipe is branched into a plurality of pipes under the heat-generating body.

10. The cooling structure according to any one of claims 1 to 9, wherein
the base material is formed of a first material with high thermal conductivity,
a second layer is formed on an outside of the first layer, the first layer is constituted of a second material with heat resistance, and the second layer is constituted of a third material with high affinity with the second material,
the cold plate is constituted of a fourth material with high thermal conductivity, and
the second material and the third material each have high affinity with the fourth material.

11. A power amplifier comprising
the cooling structure according to any one of claims 1 to 10.

12. A transmitter comprising
the power amplifier according to claim 11.
